# FASCICULE DE BREVET EUROPEEN

(11) **EP 3 267 527 B1**
(45) Date de publication et mention de la délivrance du brevet: **15.03.2023**
(21) Numéro de dépôt: 17178773.2
(22) Date de dépôt: 29.06.2017
(51) Int. Cl.: H01P 1/12, H01P 1/18

(54) **COMMUTATEUR COMPORTANT UNE STRUCTURE A BASE DE MATERIAU(X) A CHANGEMENT DE PHASE DONT UNE PARTIE SEULEMENT EST ACTIVABLE ET DISPOSITIF ET SYSTÈME COMPORTANT CE COMMUTATEUR**
UMSCHALTER, DER EINE STRUKTUR AUS MATERIAL(IEN) MIT PHASENVERÄNDERUNG UMFASST, WOVON NUR EIN TEIL AKTIVIERBAR IST UND VORRICHTUNG UND SYSTEM MIT DIESEM UMSCHALTER
SWITCH HAVING A STRUCTURE MADE OF PHASE-CHANGE MATERIALS OF WHICH ONLY ONE PORTION CAN BE ACTIVATED AND DEVICE AND SYSTEM COMPRISING SAID SWITCH

(30) Priorité: 04.07.2016 FR 1656363
(43) Date de publication de la demande: 10.01.2018
(73) Titulaire: Commissariat à l'énergie atomique et aux énergies alternatives, 75015 Paris (FR)
(72) Inventeur: NAVARRO, Gabriele, 38000 GRENOBLE (FR); SAINT-PATRICE, Damien, 26120 CHABEUIL (FR); LEON, Alexandre, 38360 SASSENAGE (FR); PUYAL, Vincent, 38000 GRENOBLE (FR); REIG, Bruno, 38430 MOIRANS (FR)
(74) Mandataire: Brevalex

(56) Documents cités:
- EP-A1- 2 706 582
- WO-A1-2009/001262
- US-A1- 2014 266 517
- US-A1- 2016 035 973
- US-A1- 2016 079 019

## Description

### DOMAINE TECHNIQUE ET ART ANTÉRIEUR

La présente demande se rapporte au domaine des commutateurs intégrant un matériau à changement de phase en particulier à ceux réalisés en couches minces et qui peuvent faire partie d'un circuit intégré ou d'un dispositif électronique. La présente invention s'applique notamment aux commutateurs RF, c'est-à-dire aux structures destinées à modifier de manière réversible les connexions électriques entre des éléments d'un circuit RF.

Les commutateurs RF sont habituellement réalisés à partir de composants électroniques tels que les transistors à effet de champ (FET pour « Field Effect Transistor ») ou les diodes PIN (pour « Positive Intrinsic Négative ») ou à l'aide de relais électro-mécaniques de type MEMS (pour « Micro Electro Mechanical System »).

Des commutateurs RF intégrant un matériau à changement de phase (PCM pour « Phase Change Material ») sont également apparus.

Le fonctionnement d'un commutateur RF à base de matériau PCM s'appuie typiquement sur deux états que ce matériau est susceptible d'adopter :
- un état amorphe à haute résistivité, qui est assimilé à un état bloqué (OFF) du commutateur lors duquel on empêche la transmission d'un signal RF entre au moins deux bornes,
- un état cristallin à faible résistivité, qui constitue un état passant (ON) du commutateur lors duquel on permet la transmission du signal RF entre les deux bornes.

Les deux états étant stables, il n'est pas nécessaire de maintenir un courant/tension pour maintenir un état ce qui permet une économie de puissance en comparaison d'autres technologies tels que les commutateurs à base de FET ou de diode PIN.

Par ailleurs, un commutateur doté d'un matériau PCM permet d'acheminer des signaux de puissance plus importante par rapport à ceux habituellement véhiculés par les commutateurs MEMS.

Le document EP 2 706 582 concerne une structure de cellule mémoire à changement de phase et prévoit une structure avec des éléments conducteurs servant d'éléments chauffant.

Le document WO 2009/001262 A1 présente également un dispositif mémoire doté d'une structure à base de matériau à changement de phase.

Le document US 2014/0266517 A1, prévoit un exemple d'interrupteur doté d'un matériau PCM inséré entre une ligne conductrice d'entrée et une ligne conductrice de sortie par lesquelles un signal RF est destiné à transiter.

Le changement de phase du matériau PCM est obtenu en faisant passer une impulsion de courant dans des électrodes dédiées disposées en contact direct avec le matériau PCM ou bien à distance de ce dernier.

Afin de limiter la consommation du commutateur on privilégie un mode de chauffage direct c'est-à-dire que l'échauffement est produit par effet joule à l'aide d'électrodes directement en contact avec le matériau PCM.

Le document US 2016/035973 A1 donne un autre exemple de commutateur à matériau PCM.

Dans de tels types de commutateurs le changement d'état de passant à bloqué ou inversement est réalisé en modifiant l'état de l'intégralité du volume de matériau PCM.

Il se pose le problème de réaliser un commutateur à matériau PCM aux performances améliorées, en particulier en termes de consommation et/ou de fiabilité.

### EXPOSÉ DE L'INVENTION

Un mode de réalisation de la présente invention concerne un commutateur tel que défini dans la revendication 1.

Des variantes sont définies dans les revendications dépendantes 2 à11.

Dans un commutateur suivant l'invention, l'agencement de la structure de matériau PCM par rapport aux éléments conducteurs et aux électrodes est prévu de sorte que la zone active n'occupe pas la totalité du volume de la structure de matériau PCM et est localisée et éloignée des éléments conducteurs. Ainsi, l'énergie nécessaire à la fusion de la zone active peut être minimisée et la cinétique de refroidissement pour conserver l'état amorphe augmentée. En confinant la zone active et en l'éloignant des éléments conducteurs, on réduit la puissance thermique nécessaire au changement d'état du matériau PCM. Une zone active déportée permet d'avoir un matériau PCM homogène au niveau de la zone active et d'éviter des zones d'interface hétérogènes amorphe/cristallines de matériau PCM au niveau des zones de contact entre les éléments conducteurs et la structure de matériau PCM. Cela permet de marquer ainsi davantage les différents états bloqué ou passant du commutateur, autrement dit de le rendre plus fiable. Cela permet également d'améliorer la durée de vie dans le temps du commutateur.

La troisième branche et/ou la quatrième branche a dans une zone en contact avec la région centrale une section plus étroite que dans une zone en contact avec l'électrode avec laquelle elle est en contact.

Cela peut permettre d'améliorer le confinement de la zone active dans une région centrale de la structure PCM.

Selon la revendication 8 qui définit une possibilité de mise en oeuvre de la structure de matériau à changement de phase, celle-ci peut être formée entre la première électrode et la deuxième électrode d'un empilement comprenant une première couche à base d'un premier matériau à changement de phase, la première couche étant disposée entre une deuxième couche et une troisième couche, la deuxième couche et la troisième couche étant à base d'au moins un deuxième matériau à changement de phase différent du premier matériau à changement de phase.

Le premier matériau à changement de phase peut avoir une température de fusion inférieure à la température de fusion du deuxième matériau à changement de phase et/ou une conductivité thermique plus élevée que la conductivité thermique du deuxième matériau à changement de phase, comme définit dans la revendication 9. Un tel agencement permet un meilleur confinement de la zone active au niveau de la première couche.

Selon la revendication 10, la structure de matériau à changement de phase peut être formée d'un empilement comprenant une première couche de matériau à changement de phase disposée entre une deuxième couche de matériau à changement de phase et une troisième couche à base de matériau à changement de phase, la deuxième couche de matériau à changement de phase et la troisième couche de matériau à changement de phase ayant des sections respectives rétrécies au fur et à mesure que l'on s'éloigne respectivement de la première électrode et de la deuxième électrode et que l'on se rapproche de la première couche de matériau à changement de phase. Un tel agencement permet également un meilleur confinement de la zone active au niveau de la première couche.

Selon la revendication 11 et selon une possibilité de mise en oeuvre de la structure de matériau à changement de phase, celle-ci peut être formée entre la première électrode et la deuxième électrode d'un empilement comprenant une première couche de matériau à changement de phase disposée entre une deuxième couche de matériau à changement de phase et une troisième couche de matériau à changement de phase, au moins la première couche de matériau à changement de phase comportant une portion amincie disposée entre une portion de la deuxième couche de matériau à changement de phase et une portion de la troisième couche de matériau à changement de phase. Un tel agencement permet également un meilleur confinement de la zone active au niveau de la première couche.

La présente invention concerne un dispositif, selon les revendications 12 et 13, comprenant au moins un commutateur selon l'une des revendications 1 à 11, et un système commutateur, selon les revendications 14 et 15, comprenant une pluralité de commutateurs selon l'une des revendications 1 à 11.

### BRÈVE DESCRIPTION DES DESSINS

La présente invention sera mieux comprise à la lecture de la description d'exemples de réalisation donnés, à titre purement indicatif et nullement limitatif, en faisant référence aux dessins annexés sur lesquels :
- la figure 1 sert à illustrer un exemple de commutateur RF ou interrupteur RF doté d'au moins un matériau PCM intégré, le dispositif étant représenté selon une vue de dessus ;
- la figure 2 donne une vue en coupe du commutateur ;
- les figures 3A et 3B donnent des exemples de réalisation d'un commutateur à structure de matériau PCM mis en oeuvre suivant l'invention avec des branches réparties autour d'une région centrale, les branches étant élargies lorsque l'on s'éloigne de la région centrale et que l'on se rapproche des électrodes de chauffage ;
- la figure 4 donne une cartographie d'échauffement du commutateur de la figure 3 obtenue par simulation ;
- les figures 5A et 5B servent à illustrer une variante de mise en oeuvre d'un commutateur comprenant une structure de matériau PCM en forme de croix avec des branches qui s'étendent horizontalement et des branches qui s'étendent verticalement ;
- la figure 6A sert à illustrer une structure de matériau PCM pour commutateur avec un empilement de couches de matériaux à changement de phase avec avantageusement des températures de fusion respectives différentes et/ou des conductivités thermiques différentes ;
- la figure 6B sert à illustrer une structure de matériau PCM pour commutateur avec un empilement de couches de matériau(x) à changement de phase de forme rétrécie au fur et à mesure que l'on se rapproche du centre de la structure ;
- la figure 6C sert à illustrer une structure de matériau PCM pour commutateur avec un empilement de couches de matériau(x) à changement de phase, une des couches ayant une partie plus mince en son centre qu'en périphérie ;
- la figure 7 sert à illustrer un dispositif de commutation comportant une pluralité de commutateurs à base de matériau PCM mis en parallèle, les électrodes de chauffage étant agencées en parallèle ;
- la figure 8 sert à illustrer un dispositif de commutation comportant une pluralité de commutateurs à base de matériau PCM mis en parallèle, les électrodes de chauffage étant agencées en série ;
- les figures 9A-9C, 10A-10C servent à illustrer un exemple de procédé de fabrication d'un commutateur à structure de matériau à changement de phase ayant des branches réparties dans un plan horizontal ;
- les figures 11A-11M servent à illustrer un autre exemple de procédé de fabrication d'un commutateur à structure de matériau à changement de phase ayant des branches réparties dans un plan horizontal et des branches réparties dans un plan vertical.

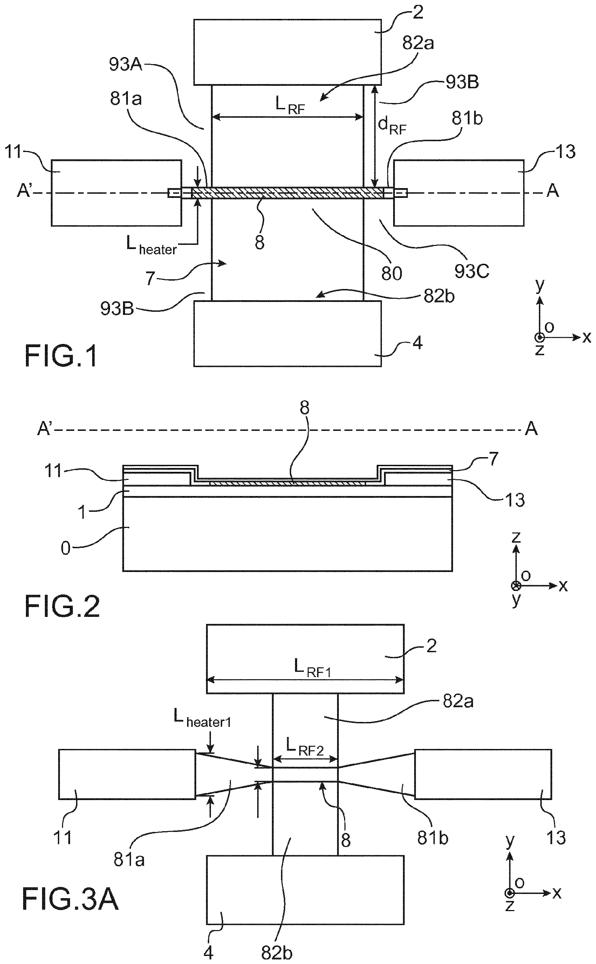

Les figures 1, 2, 6A et 6C ne font pas partie de l'invention.

En outre, dans la description ci-après, des termes qui dépendent de l'orientation du dispositif tels qu'« horizontal », « vertical » s'appliquent en considérant que la structure est orientée de la façon illustrée sur les figures.

Des parties identiques, similaires ou équivalentes des différentes figures portent les mêmes références numériques de façon à faciliter le passage d'une figure à l'autre.

Les différentes parties représentées sur les figures ne le sont pas nécessairement selon une échelle uniforme, pour rendre les figures plus lisibles.

### EXPOSÉ DÉTAILLÉ DE MODES DE RÉALISATION PARTICULIERS

Un exemple de commutateur selon conventionnel est illustré sur la figure 1 donnant une vue de dessus.

Ce commutateur permet de modifier les connexions d'au moins un circuit (non représenté) qui, dans cet exemple de réalisation, est destiné à véhiculer des signaux radio-fréquences (RF). Le commutateur est ainsi un commutateur RF apte à acheminer ou à interrompre l'acheminement d'un signal RF entre une première portion de circuit et une deuxième portion de circuit, en fonction de l'état d'au moins un matériau à changement de phase (PCM) agencé entre ces deux portions. Le dispositif décrit ici peut remplir la fonction d'un interrupteur bistable. On utilisera néanmoins le terme « commutateur » tout au long du présent exposé détaillé. Le signal RF véhiculé a une fréquence qui peut être comprise par exemple entre plusieurs mégahertz et plusieurs centaines de gigahertz et une puissance par exemple de l'ordre de 40 dBm.

Le commutateur comporte ainsi un premier élément conducteur 2 par lequel au moins un signal RF est destiné à entrer et qui est connecté avec la première portion (non représentée) de circuit RF et un deuxième élément conducteur 4 connecté avec la deuxième portion (non représentée) du circuit RF et par lequel le signal RF est ainsi destiné à sortir. Les éléments conducteurs 2, 4 sont par exemple à base d'un matériau métallique tel que de l'or (Au) et sous forme de plots d'épaisseur par exemple de l'ordre de 1 µm.

Le premier élément conducteur 2 et le deuxième élément conducteur 4 forment ainsi deux terminaisons d'une ligne de transmission de signal électrique RF, ces deux terminaisons étant séparées l'une de l'autre par une structure à base d'au moins un matériau à changement de phase 7 et étant connectées électriquement à, et avantageusement en contact avec, cette structure.

Le commutateur est susceptible d'adopter un premier état appelé état « passant » dans lequel le premier élément conducteur 2 et le deuxième élément conducteur 4 sont connectés l'un à l'autre de sorte qu'au moins un signal RF peut transiter du premier élément conducteur 2 au deuxième élément conducteur 4. Le commutateur est également susceptible d'adopter un deuxième état appelé état « bloqué » dans lequel entre le premier élément conducteur 2 et le deuxième élément conducteur 4, la transmission d'un signal RF est empêchée.

Les états « passant » et « bloqué » du commutateur correspondent à différents états d'un volume ou d'une zone 8 de la structure de matériau 7 à changement de phase appelée « zone active ». Le matériau 7 à changement de phase peut être en particulier un matériau apte à passer d'un état amorphe à un état cristallin et inversement en fonction de la température à laquelle celui-ci est porté. Ainsi, la zone active 8 de matériau 7 à changement de phase disposé entre les éléments conducteurs 2, 4 est susceptible, lorsque le matériau 7 est sous forme amorphe, d'adopter un état de forte résistivité, et lorsque le matériau 7 se trouve sous forme cristalline, d'adopter un état de faible résistivité. Par « faible résistivité » on entend une résistivité qui peut être comprise par exemple entre 10⁻⁴ ohm.cm et 10⁻² ohm.cm. Par « forte résistivité », on entend une résistivité qui peut être comprise par exemple entre 10 ohm.cm et 1000 ohm.cm.

Lorsque le matériau à changement de phase 7 de la zone active 8 est dans son état cristallin faiblement résistif, le signal RF est transmis du premier élément conducteur 2 vers le deuxième élément conducteur 4 tandis que lorsque le matériau à changement de phase 7 de la zone active 8 est dans son état amorphe fortement résistif, le signal RF est réfléchi et n'est donc pas transmis vers le deuxième élément conducteur 4.

En changeant l'état du matériau 7 entre son état amorphe et son état cristallin on peut donc obtenir une fonction d'interrupteur.

Le matériau 7 à changement de phase peut être par exemple à base d'un chalcogénure ou d'un alliage de chalcogénures par exemple à base de Germanium et de Tellure tel que du GeTe ou bien à base de Germanium, de Tellure et d'Antimoine (GeₓSb_{y}Te_{z}). De tels matériaux ont avantageusement un rapport de résistivité élevé, par exemple de l'ordre de 10³ et qui peut atteindre 10⁶ entre leur état de faible résistivité et leur état de forte résistivité. L'épaisseur (dimension mesurée parallèlement à l'axe z du repère orthogonal [0; x ; y ; z]) de matériau à changement de phase 7 peut être par exemple de l'ordre de 100 nm.

Pour faire passer le matériau à changement de phase 7 d'un état cristallin à un état amorphe et inversement, le dispositif est doté de moyens d'activation du matériau PCM 7, ces moyens étant ici des moyens de chauffage de préférence de type électrique. Un moyen de chauffage direct configuré pour injecter un signal d'activation électrique est ici mis en oeuvre. Le signal d'activation est typiquement sous forme d'un courant injecté dans le matériau PCM 7 qui est alors chauffé par effet joule. Le moyen de chauffage direct est doté d'électrodes 11, 13 en contact avec la structure de matériau PCM 7 et entre lesquelles cette structure est disposée.

Lorsqu'une impulsion de courant appropriée passe entre les deux électrodes 11 et 13 à travers le matériau 7 PCM, la zone active 8 de ce matériau passe d'un état cristallin à un état amorphe fortement résistif. La zone active 8 est alors configurée de sorte à bloquer le passage d'un signal RF entre le premier élément conducteur 2 et le deuxième élément conducteur 4.

Pour faire passer le matériau 7 PCM de la zone active 8 de son état amorphe à son état cristallin, on applique une autre impulsion de courant appropriée entre les deux électrodes 11, 13 à travers le matériau 7 PCM.

L'impulsion de courant peut avoir une intensité entre plusieurs centaines de micro-ampères et plusieurs dizaines de mA suivant la quantité de matériau PCM.

On peut par exemple prévoir des impulsions de l'ordre de 1 mA et d'une durée de l'ordre de 10 µs pour effectuer une cristallisation, tandis que pour réaliser une amorphisation, les impulsions de courant ont une intensité plus importante, par exemple de l'ordre de 10 mA et une durée plus courte, par exemple de l'ordre de 50 ns.

Les électrodes 11, 13 du moyen de chauffage direct sont dissociées des éléments conducteurs 2, 4 par lequel le signal RF transite. Les électrodes 11, 13 peuvent être sous forme de plots d'épaisseur par exemple de l'ordre de 1 µm et à base d'un matériau conducteur différent de celui des éléments conducteurs 2, 4 par exemple tel que du TiN.

Dans le commutateur mis en oeuvre suivant l'invention, le volume de la zone active 8 (zone hachurée sur la figure 1) destinée à changer d'état ne correspond pas à l'intégralité du volume de matériau à changement de phase 7. On ne modifie en effet l'état que d'un volume donné du matériau à changement de phase et on conserve des volumes restants de matériau à changement de phase dont l'état n'est pas modifié autour de la zone active.

Ainsi, même lorsque le commutateur est dans un état bloqué, pour lequel on empêche un signal de transiter entre le premier élément conducteur et le deuxième élément conducteur, seule la zone active 8 est mise sous forme amorphe tandis que des volumes restants de matériau à changement de phase 7 situées de part et d'autre de la zone active 8 se trouvent sous forme cristalline. Dans un tel dispositif, on éloigne la zone active 8 susceptible de changer d'état des électrodes 11, 13 afin de réduire la puissance nécessaire au changement d'état. Une zone active 8 ainsi déportée permet de limiter la consommation du commutateur. Le fait de confiner la zone active dans un volume donné, en particulier situé dans une région centrale de la structure de matériau à changement de phase permet également d'obtenir une meilleure homogénéité de l'état (amorphe ou cristallin) du matériau à changement de phase et d'augmenter ainsi la fiabilité du commutateur et d'améliorer ses performances en termes de vitesse.

Pour une intensité donnée de courant d'activation injecté dans la première électrode de chauffage, la disposition de la zone active 8 dépend en particulier de l'agencement de la structure de matériau à changement de phase 7, en particulier par rapport aux électrodes 11, 13 et aux éléments conducteurs 2, 4.

Dans l'exemple de la figure 1, le matériau à changement de phase est réparti sous forme d'une région centrale 80 et de branches 81a, 81b, 82a, 82b distinctes réparties autour de cette région centrale 80 les branches s'étendant depuis la région centrale jusque vers respectivement la première électrode 11, la deuxième électrode 13, le premier élément conducteur 2, le deuxième élément conducteur 4.

La région centrale 80 et les branches 81a, 81b forment un premier bloc disposé entre les éléments conducteurs 2 et 4, tandis que la région centrale 80 et les branches 82a, 82b forment un deuxième bloc qui s'étend entre les électrodes 11, 13, et croise ou chevauche le premier bloc. Dans cet exemple particulier de réalisation le premier bloc est orthogonal au deuxième bloc, les branches 81a, 81b, 82a, 82 s'étendant ainsi dans quatre régions différentes.

La région centrale 80 et les branches 81a, 81b, 82a, 82b réalisent ainsi une configuration en forme de croix à quatre branches dont les extrémités sont situées en contact respectivement avec la première électrode 11, le premier élément conducteur 2, le deuxième élément conducteur 13, et la deuxième électrode 4. Les branches 81a, 81b, 82a, 82b sont disjointes les unes des autres et peuvent être séparées deux à deux par une région isolante prévue autour du matériau à changement de phase. Cette région isolante, par exemple sous forme d'au moins un matériau diélectrique, comporte une portion 93A située entre la branche 81a connectée à la première électrode 11 et la branche 82a connectée 11 au premier élément conducteur 2. Une portion 93B isolante est située entre la branche 82a connectée au premier élément conducteur 2 et la branche 81b connectée à la deuxième électrode 13. Une autre portion 93C isolante est située entre la branche 81b connectée à la deuxième électrode 13 et la branche 82b connectée au deuxième élément conducteur 4. Une autre portion 93D isolante est disposée entre la branche 82b connectée au deuxième élément conducteur 4 et la branche 81a connectée à la première électrode 11.

Dans cet exemple, les branches 81a, 81b, sont orthogonales aux branches 82a, 82b.

Le support sur lequel les branches 81a, 81b, 82a, 82b sont agencées peut être un substrat 0 semi-conducteur comme illustré de manière schématique sur la figure 2 donnant une vue en coupe transversale A'A.

Le substrat 0 semi-conducteur est par exemple en silicium et passivé par l'intermédiaire d'une couche isolante 1 par exemple à base de SiO₂ sur laquelle la structure de matériau PCM est disposée. Le matériau PCM 8 est ici réparti en une couche qui s'étend sur et contre les électrodes 11, 13.

On prévoit de préférence les branches 81a, 81b, dirigées vers les électrodes 11, 13 avec une largeur Lₕₑₐₜₑᵣ inférieure à la largeur L_{RF} des branches 82a, 82b, dirigées vers les éléments conducteurs 2, 4. Les largeurs Lₕₑₐₜₑᵣ et L_{RF} sont des dimensions de la structure de matériau à changement de phase mesurées parallèlement au plan principal du support, i.e. un plan parallèle au plan [0 ; x ; y].

On définit également une dimension d_{RF} de la branche 82a ou 82b mesurée dans un axe parallèle à celui dans lequel la branche 82a ou 82b s'étend entre une extrémité d'une branche 82a, 82b et un bord latéral d'une des branches 81a, 81b. Cette dimension d_{RF} correspond ici à une distance entre un élément conducteur 2 ou 4 et la région centrale 80 de la structure de matériau à changement de phase.

En adaptant les largeurs Lₕₑₐₜₑᵣ et L_{RF} ainsi que la dimension d_{RF}, on optimise les performances du commutateur en termes de courant, tension d'actionnement. On peut prévoir la largeur L_{RF} des branches 82a, 82b comprise par exemple entre 10 nm à 100 µm, la largeur Lₕₑₐₜₑᵣ des branches 81a, 81b étant comprise par exemple entre 10 nm à 1 µm, et la dimension d_{RF} comprise par exemple entre 100 nm à 10 µm. Avantageusement, la largeur L_{RF} est de l'ordre de 1000 nm, tandis que la largeur Lₕₑₐₜₑᵣ est de l'ordre de 400 nm. La dimension d_{RF} peut être dans ce cas par exemple de l'ordre de 500 nm. Avec de telles dimensions et une structure de matériau à changement de phase à base de GeTe et d'épaisseur de l'ordre de 100 nm, on peut mettre en oeuvre un commutateur avec des résistances R_{ON} à l'état passant et R_{OFF} à l'état bloqué de la structure de matériau à changement de phase, par exemple respectivement de l'ordre de 20 Ohm et de 2.10⁶ Ohm pour une tension d'activation de l'ordre de 20 V et un courant d'activation de l'ordre de 20 mA.

Une configuration améliorée de la structure de matériau à changement de phase 7 est donnée sur la figure 3A.

Cette structure diffère de celle décrite précédemment, en ce que les branches 81a, 81b, en contact respectivement avec l'électrode 11 et l'électrode 13 sont cette fois plus étroites à proximité de la région centrale 80 qu'au niveau de la périphérie de la structure de matériau à changement de phase autrement dit qu'au niveau des électrodes 11, 13 et des éléments conducteurs 2, 4.

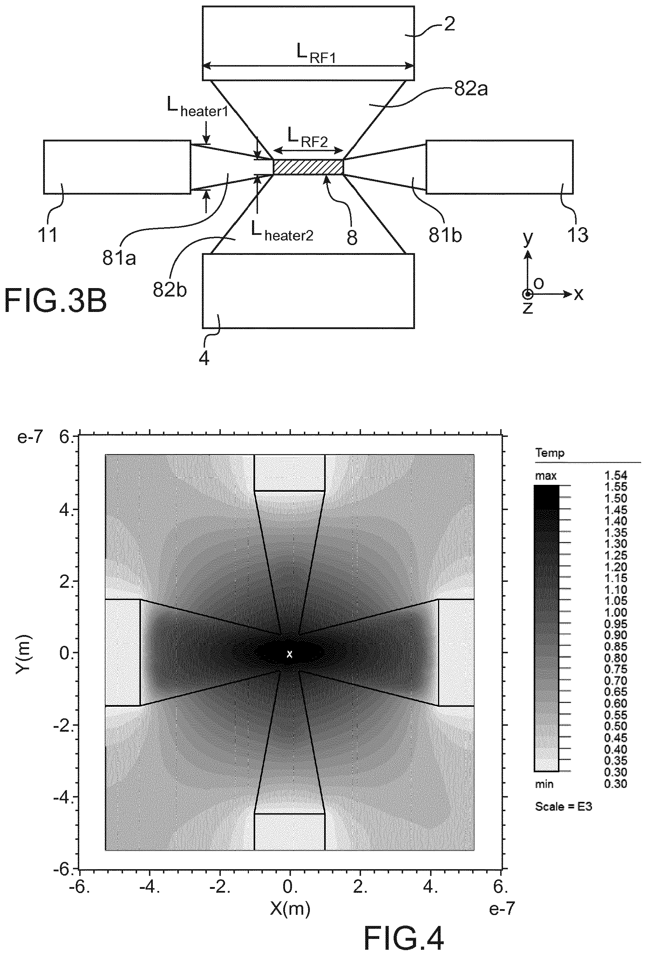

La figure 3A montre un exemple de réalisation particulier du rétrécissement réalisé. Les branches 81a, 81b, en contact ont une section transversale qui est variable et varie en particulier de manière linéaire. Par section transversale, on entend une section prise dans un plan orthogonal au plan principal d'un support sur lequel le commutateur est disposé. Par « plan principal » du support, on entend un plan passant par le support et qui est parallèle au plan [0 ; x ; y] du repère orthogonal [0 ; x ; y ; z] donné sur la figure 3.

Avec un tel agencement, une section de la structure PCM au niveau de la région centrale ou de de la zone de PCM active prise orthogonalement à la direction du courant de chauffage circulant entre les électrodes 11, 12 est inférieure à la surface d'une zone de matériau PCM en contact avec les électrodes de chauffage 11, 12 la structure PCM prise orthogonalement à la direction du courant de chauffage.

Cette forme rétrécie des branches 81a, 81b au niveau de la région centrale 80 de la structure de matériau à changement de phase permet de davantage concentrer la zone active 8 dans la région centrale 80 de la structure de matériau à changement de phase.

En localisant la zone active au centre de la structure et en limitant la possibilité aux zones au contact des électrodes de chauffage de changer de phase, on évite ainsi un problème de surconsommation électrique et de diminution de la fiabilité du commutateur au cours du temps. On empêche notamment une dégradation de la structure PCM dans la zone en contact avec les électrodes 11, 13.

Les branches 81a, 81b, ont ainsi une largeur Lₕₑₐₜₑᵣ₁ dans une zone en contact respectivement avec les électrodes 11, 13 plus importante qu'une largeur Lₕₑₐₜₑᵣ₂ à proximité de la région centrale 80 de la structure de matériau à changement de phase. On peut prévoir le rétrécissement des branches 81a, 81b de sorte que Lₕₑₐₜₑᵣ₁ - Lₕₑₐₜₑᵣ₂ est égal à au moins 30 nm, et par exemple de l'ordre de 100 nm.

Avantageusement, on peut également prévoir une forme rétrécie des branches 82a, 82b.

Une autre configuration améliorée de la structure de matériau à changement de phase 7 est ainsi donnée sur la figure 3B.

Cette structure diffère de celle décrite précédemment, en ce que les branches 82a, 82b, en contact respectivement avec l'élément conducteur 2 et avec l'élément conducteur 4 sont cette fois plus étroites à proximité de la région centrale 80 qu'au niveau de la périphérie de la structure de matériau à changement de phase autrement dit qu'au niveau des éléments conducteurs 2, 4.

On augmente ainsi l'effet de confinement de la zone active au centre la structure PCM.

La figure 3B montre une exemple de réalisation dans lequel la section transversale des branches 82a, 82b varie de manière linéaire.

De même, de façon avantageuse, les branches 82a, 82b, peuvent être prévues avec une largeur L_{RF1} dans une zone en contact respectivement avec les éléments conducteurs 2, 4 plus importante qu'une largeur L_{RF2} à proximité de la région centrale 80 de la structure de matériau à changement de phase. On peut également prévoir le rétrécissement des branches 82a, 82b de sorte que L_{RF1} - L_{RF2} est égal à au moins 30 nm, et par exemple de l'ordre de 100 nm.

On peut envisager une forme rétrécie d'une seule des branches 81a 81b et/ou 82a, 82b, mais on met de préférence en oeuvre une forme rétrécie pour chacune des branches. Cela permet de davantage concentrer la zone active 8 dans la région centrale 80 de la structure de matériau à changement de phase.

Cela est confirmé par un résultat de simulation illustré sur la figure 4 qui donne une cartographie d'échauffement de la structure de matériau à changement de phase du commutateur décrit précédemment en liaison avec la figure 3B. Une telle cartographie peut être obtenue par exemple à l'aide d'un outil de simulation et d'analyse numérique utilisant la méthode des éléments finis tel que le logiciel FlexPDE.

La zone active 8 du commutateur est de préférence suffisamment large pour pouvoir interrompre le signal RF mais suffisamment étroite afin de limiter la consommation.

De préférence, on prévoit une forme des branches 81a, 81b, de sorte que le volume de la zone active 8 est égale à au plus 1/3 du volume total occupé par les branches 81a, 81b.

On choisit par exemple la forme des branches de manière à avoir une proportion par exemple d'1/3, 1/3, 1/3, respectivement entre le volume d'une portion de branche 81a dont l'état ne change pas, le volume d'une portion de branche 81b dont l'état ne change pas, et le volume de la zone active 8 apte à changer d'état.

Dans les exemples de réalisation qui ont été donnés précédemment les moyens de chauffage ont un agencement horizontal avec des électrodes 11, 13 situées dans un même plan, sensiblement parallèle ou parallèle au plan principal du support/substrat.

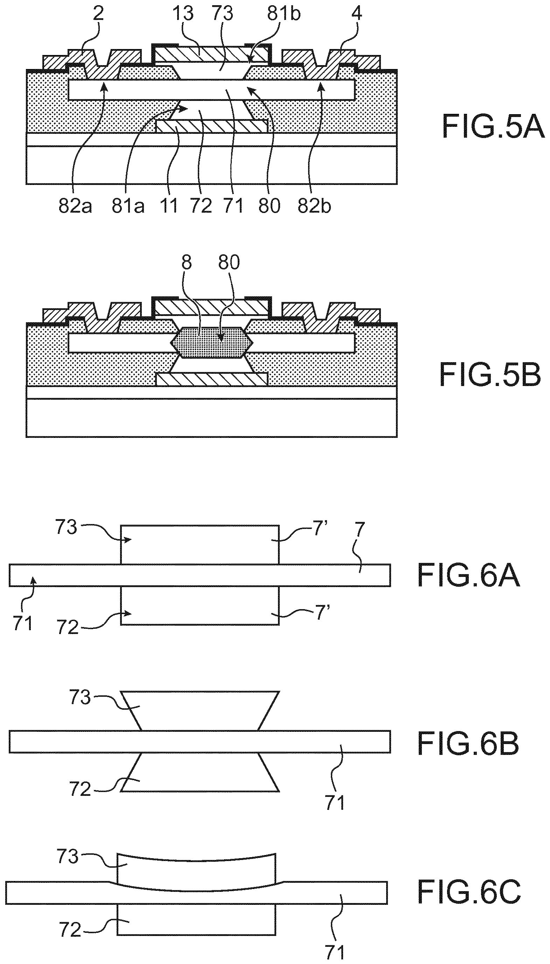

La figure 5A illustre une variante de réalisation avec une répartition verticale des moyens de chauffage, les électrodes 11, 13 étant situées dans un même plan réalisant un angle non-nul et en particulier orthogonal au plan principal du support, tandis que les éléments conducteurs 2, 4 sont situés dans un même plan parallèle au plan principal du support. On réduit ainsi l'encombrement du commutateur dans un plan parallèle au support.

La structure de matériau à changement de phase est dans cet exemple formée d'un empilement de plusieurs couches 71, 72, 73 de matériau à changement de phase, par exemple du GeTe, réparties selon une région centrale 80, et autour de la région centrale 80 de branches périphériques 81a, 81b, 82a, 82b auxquelles les électrodes 81a, 81b et les éléments conducteurs 82a, 82b sont respectivement connectées.

Dans cet exemple, les branches 82a, 82b connectées respectivement aux éléments conducteurs 2, 4 s'étendent dans un premier plan et sont formées à partir d'une première couche 71 de l'empilement, tandis que les branches 81a, 81b connectées aux électrodes 11, 13, sont formées respectivement à partir d'une deuxième couche 72 et d'une troisième couche 73 de l'empilement, et contenues dans un deuxième plan non-parallèle au premier plan et en particulier orthogonal au premier plan. La structure en croix de matériau à changement de phase est entourée d'une région isolante 93, par exemple formée d'une ou plusieurs couches de SiN.

On voit sur cette figure, que les branches 81a, 81b connectées aux électrodes 11, 13, ont une section plus importante dans une zone en contact avec les électrodes 11, 13 que dans une zone en contact ou à proximité de la région centrale 80 de la structure PCM.

La figure 5B illustre la localisation de la zone active 8 dans une telle structure. Là encore, la zone active 8, c'est-à-dire la zone de matériau PCM susceptible de changer d'état ne représente qu'une partie du volume total de matériau PCM réparti entre les électrodes 11, 13 et entre les éléments conducteurs 2, 4. La zone active est dans cet exemple est confinée au niveau de la région centrale 80 de la structure de matériau PCM et ne s'étend pas aux extrémités des branches 81a, 81b, 82a, 82b. La région centrale 80 entre les branches est apte à passer d'un état cristallin à un état amorphe et inversement, tandis que les extrémités des branches 81a, 81b, 82a, 82b restent dans un état cristallin.

Les figures 6A, 6B, 6C illustrent des variantes d'empilement de couches de matériau(x) à changement de phase susceptibles d'être intégrées au commutateur, et en particulier à celui des figures 5A, 5B. Avantageusement il peut s'agir de couches de nature différentes.

Dans l'empilement de la figure 6A, la première couche 71 de matériau PCM dans laquelle la zone active 8 est apte à être réalisée est à base d'un matériau à changement de phase ayant une première température de fusion, tandis que la deuxième couche 72 et la troisième couche 73 disposées respectivement sous et sur la première couche 71 sont à base d'un matériau à changement de phase ayant une deuxième température de fusion, plus élevée que la première température de fusion.

Afin de mieux confiner la zone active dans la structure de matériau PCM, on peut prévoir de mettre en oeuvre une structure avec des régions, en particulier sous forme de couches empilées, de matériaux PCM ayant des températures de fusion différentes et/ou des conductivités thermiques différentes.

On prévoit par exemple la première couche 71 en Ge₅₀Te₅₀ de température fusion de l'ordre de 750°C et les deuxième et troisième couches 72, 73, en Ge₇₀Te₃₀ avec une température fusion de l'ordre de 900°C. Dans un tel exemple de réalisation, en disposant la couche 71 entre deux couches de matériau ayant une température de fusion plus élevée, on obtient un meilleur confinement de la zone active, celle-ci étant apte à être localisée principalement dans une portion de la première couche 71 située entre et en contact avec les deuxième et troisième couches 72, 73 de matériau à changement de phase.

En variante, on peut prévoir une première couche 71 de conductivité thermique plus importante que la deuxième couche 72 de matériau PCM et que la troisième couche de matériau PCM. Un exemple d'empilement est formé par exemple à l'aide d'une première couche 71 en Ge₅₀Te₅₀ disposée entre deux couches à base d'un matériau PCM de conductivité thermique plus faible, par exemple du Ge₂Sb₂Te₅.

Un autre exemple d'empilement illustré sur la figure 6B prévoit des couches 72, 73 ayant une surface de contact avec les électrodes 11, 13 de chauffage supérieure à la surface de contact avec la première couche de matériau à changement de phase. Les couches 72, 73 ont une forme rétrécie au fur et à mesure que l'on s'éloigne des électrodes de chauffage et que l'on se rapproche de la zone de la première couche 71 formant la région centrale de la structure de matériau PCM dans laquelle la zone active est prévue pour être majoritairement répartie.

Dans l'exemple d'empilement de la figure 6C, la première couche 71 qui est située entre les deuxième et troisième couches 72, 73 comporte cette fois une partie amincie disposée entre et en contact avec les deuxième et troisième couches 72, 73. Cette partie de la première couche 71 plus mince que ses bords forme dans cet exemple la région centrale de la structure de matériau PCM dans laquelle la zone active est prévue pour être majoritairement répartie. On obtient ainsi une forme de section rétrécie telle qu'évoquée précédemment avec un rétrécissement au fur et à mesure que l'on se rapproche d'une région centrale de la structure PCM et que l'on s'éloigne des électrodes et/ou des éléments conducteurs.

Un autre exemple d'empilement comprend des couches 71, 72 ou 73 ayant, comme sur la figure 6B une section variable lorsqu'on considère un plan vertical (autrement dit un plan parallèle au plan [O,x,z]), la première couche 71 ayant, comme sur la figure 3, une forme de croix avec des branches rétrécies vers le centre de l'empilement.

Un commutateur selon l'un ou l'autre des exemples de réalisation précédemment décrits peut être intégré dans un système commutateur comprenant plusieurs commutateurs en parallèles. Un tel système peut éventuellement intégrer un ou plusieurs commutateurs à agencement vertical tel qu'illustré sur les figures 5A-5B et un ou plusieurs commutateurs à agencement horizontal tel qu'illustré par exemple sur les figures 1 ou 3.

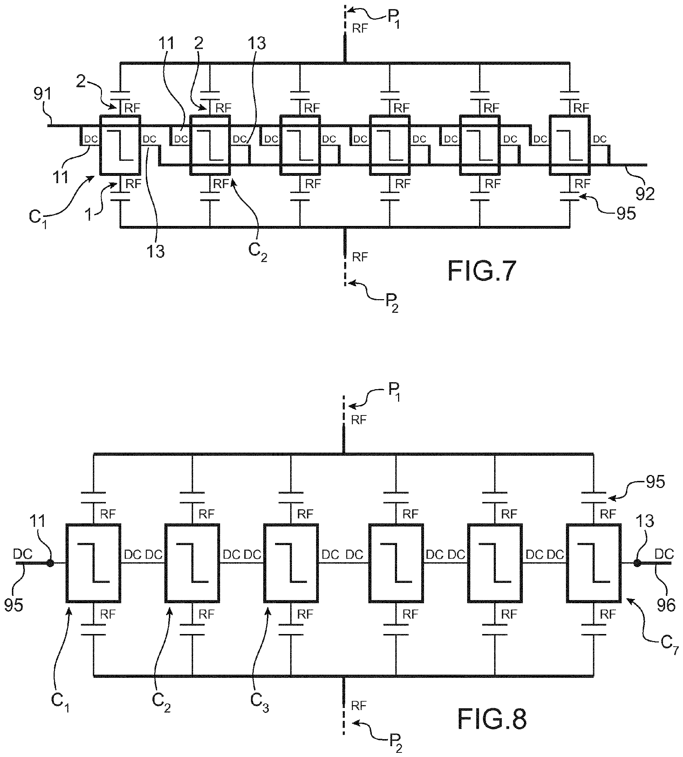

Un exemple de mise en oeuvre d'un système à commutateurs connectés en parallèle est donné sur la figure 7.

Pour acheminer ou interrompre l'acheminement d'au moins un signal RF entre une première portion P1 d'un circuit et une deuxième portion P2 de circuit on utilise donc cette fois une pluralité de commutateurs C₁, C₂,..., Cₖ (avec k égal à 7 dans l'exemple illustré). Les commutateurs C₁, ..., C₇ sont agencés en parallèle de sorte que leurs premiers éléments conducteurs 2 respectifs sont connectés entre eux tandis que leurs deuxièmes éléments conducteurs 4 respectifs sont également connectés entre eux. Dans l'exemple de la figure 7, les commutateurs C₁, C₂,..., Cₖ sont agencés de manière à ce que les premières électrodes 11 de chauffage respectives des commutateurs soient connectées entre elles et à une première ligne de polarisation 91 tandis que les deuxièmes électrodes 13 de chauffage respectives des commutateurs sont également connectées entre elles et à une deuxième ligne de polarisation 92.

Un avantage d'un tel système solution est qu'une faible tension DC de pilotage Vmax est appliquée aux lignes de polarisation 91, 92 et que cette tension Vmax est égale à la tension de seuil V_{TH} encore appelée tension de basculement d'un seul commutateur. La tension de seuil V_{TH} dépend de l'épaisseur de la structure de matériau PCM au niveau de la zone active. Pour une zone active d'épaisseur de l'ordre de 100 nm, la tension de seuil est par exemple de l'ordre de 1V.

Une variante de système commutateur doté de plusieurs commutateurs C1,....,C7 en parallèles est illustrée sur la figure 8. Cet exemple de configuration diffère de la précédente en ce que les électrodes de chauffage 11, 13 sont cette fois agencées en série de sorte qu'une première électrode de chauffage 11 d'un commutateur C2 est connectée à la deuxième électrode 13 d'un commutateur précédent C1, tandis que la deuxième électrode 13 de chauffage 13 du commutateur C2 est connectée à la première électrode 11 d'un commutateur C3 suivant.

Des moyens de polarisation sont cette fois prévus pour appliquer une tension DC entre la première électrode 11 d'un premier commutateur C1 situé à une extrémité 95 de l'ensemble de commutateurs C1,....,C7 et la deuxième électrode 13 d'un autre commutateur C7 situé à une autre extrémité 96 de l'ensemble de commutateurs C1,....,C7 mis en parallèles. Une telle configuration permet d'avoir un courant DC (IDC-TOT) de commande équivalent à celui d'un seul commutateur et une meilleure transition d'un état bloqué (OFF) à un état passant (ON) du fait d'une meilleure uniformité entre les profils respectifs de température des différents commutateurs. Dans un cas, par exemple, où le système commutateur est formé de plusieurs commutateurs du type de celui illustré sur la figure 1, ce dispositif unitaire sera mis en parallèle. Pour k commutateurs en parallèle on divise par k la résistance R_{ON} à l'état passant et la résistance R_{OFF} tout en conservant les tensions et courants d'activation d'un seul commutateur. Dans ce cas avec k commutateurs en parallèle, on peut choisir les dimensions L_{RF} par exemple égale à k*1000 nm, d_{RF} par exemple de l'ordre de 500 nm et Lₕₑₐₜₑᵣ par exemple de l'ordre de 400 nm.

Dans l'un ou l'autre des systèmes à commutateurs en parallèle décrits précédemment, on intègre de préférence un condensateur de découplage 95 entre le premier élément conducteur 2 de chaque commutateur et la première portion de circuit P1 et entre le premier élément conducteur 4 de chaque commutateur et la deuxième portion de circuit P2.

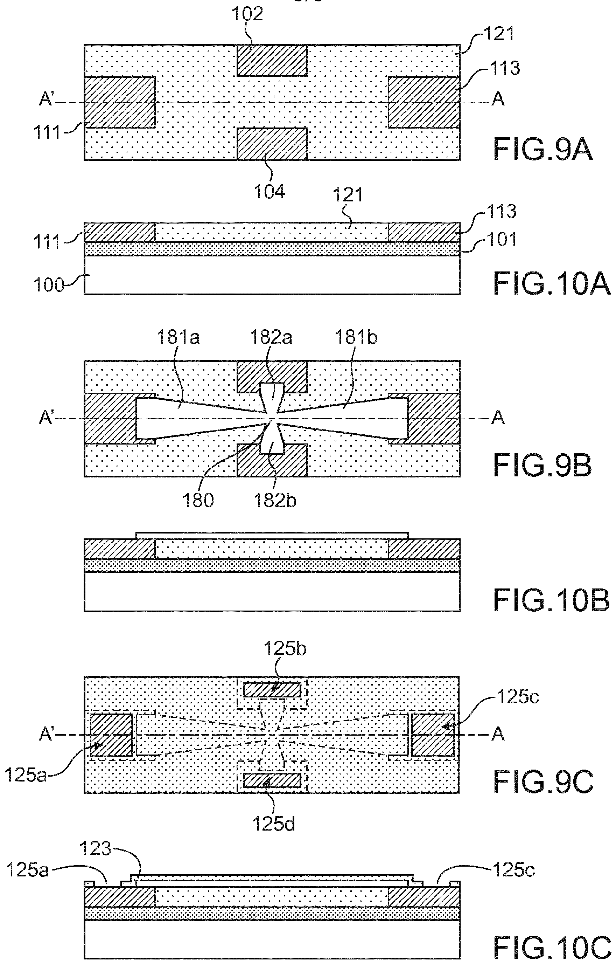

Un exemple de procédé de fabrication d'un commutateur tel que décrit précédemment va à présent être donné en liaison avec les figures 9A-9C (illustrant le dispositif en cours de réalisation selon une vue de dessus), les figures 10A-10C (illustrant le dispositif en cours de réalisation selon une vue en coupe transversale réalisée selon un axe A'A).

Le support de départ est ici un substrat 100 qui peut être semi-conducteur et par exemple en silicium. Le substrat est typiquement passivé par une couche de passivation 101 isolante, par exemple à base de dioxyde de silicium (SiOz) d'épaisseur par exemple de l'ordre de 500 nm.

Sur ce support, on réalise tout d'abord les moyens de chauffage sous forme d'électrodes 111, 113. Les électrodes sont réalisées par dépôt, par exemple de type PVD (pour « Physical Vapor deposition »), puis photolithographie et gravure d'un empilement de matériaux conducteurs, par exemple d'une couche de Ti d'épaisseur de l'ordre de 10 nm, sur laquelle repose une couche de TiN par exemple de l'ordre de 40 nm, une couche d'AICu par exemple de l'ordre de 440 nm, une couche de Ti par exemple de l'ordre de 10 nm, une couche de TiN par exemple de l'ordre de 100 nm.

Dans cet exemple de réalisation particulier, on forme les éléments conducteurs 102, 104 du commutateur par lesquels un signal est destiné à transiter dans la même couche ou le même empilement que les électrodes 111, 113 d'activation ou de chauffage du matériau à changement de phase.

On effectue ensuite un dépôt d'une couche de matériau isolant 121 par exemple en SiO₂ d'épaisseur par exemple de l'ordre de 300 nm pour former une isolation autour des électrodes 111, 113 et des éléments conducteurs 102, 104 (figures 9A et 10A).

Le matériau isolant 121 peut être amené à recouvrir les électrodes 111, 113 et les éléments conducteurs 102, 104. Dans ce cas, pour permettre de dévoiler la face supérieure des électrodes 111, 113 et des éléments conducteurs 102, 104, on effectue une planarisation par CMP (pour « Chemical Mechanical Polishing/Planarization »).

On forme ensuite une structure de matériau à changement de phase 7, par dépôt d'une couche par exemple en GeTe, ayant une épaisseur typiquement de l'ordre de 100 nm, dans laquelle on réalise au moins un motif en forme de croix (figures 9B et 10B).

Le motif réalisé peut être du de celui décrit précédemment en liaison avec la figure 1 ou avec la figure 3 et comporte une région centrale 180 autour de laquelle sont réparties des branches 181a, 182a, 181b, 182b distinctes respectivement en contact avec une première électrode 111, un premier élément conducteur 102, une deuxième électrode 113, un deuxième élément conducteur 104. La structuration de la couche de matériau à changement de phase 7 est typiquement réalisée par gravure IBE (pour « Ion Beam Etching ») à travers un masque résine.

Afin de passiver la structure de matériau PCM 7 on forme ensuite une couche isolante 123, par exemple à base de SiN et d'épaisseur de l'ordre de 200 nm. Dans cette couche isolante 123, on effectue des ouvertures 125a, 125b, 125c, 125d distinctes dévoilant respectivement la première électrode 111, le premier élément conducteur 102, le deuxième électrode 113, le deuxième élément conducteur 104. On peut ainsi reprendre les contacts sur les électrodes 111, 113 et les éléments conducteurs 102, 104 (figures 9C et 10C).

Dans l'exemple de procédé qui vient d'être décrit, le commutateur réalisé est de type à agencement horizontal de la structure de matériau à changement de phase ainsi que des électrodes et éléments conducteurs répartis autour de cette structure.

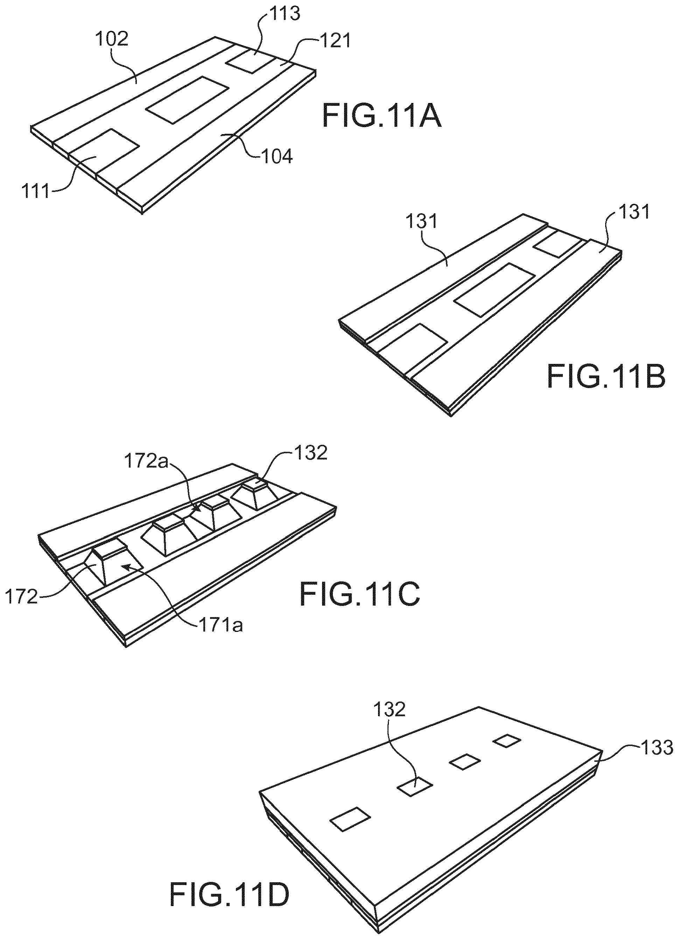

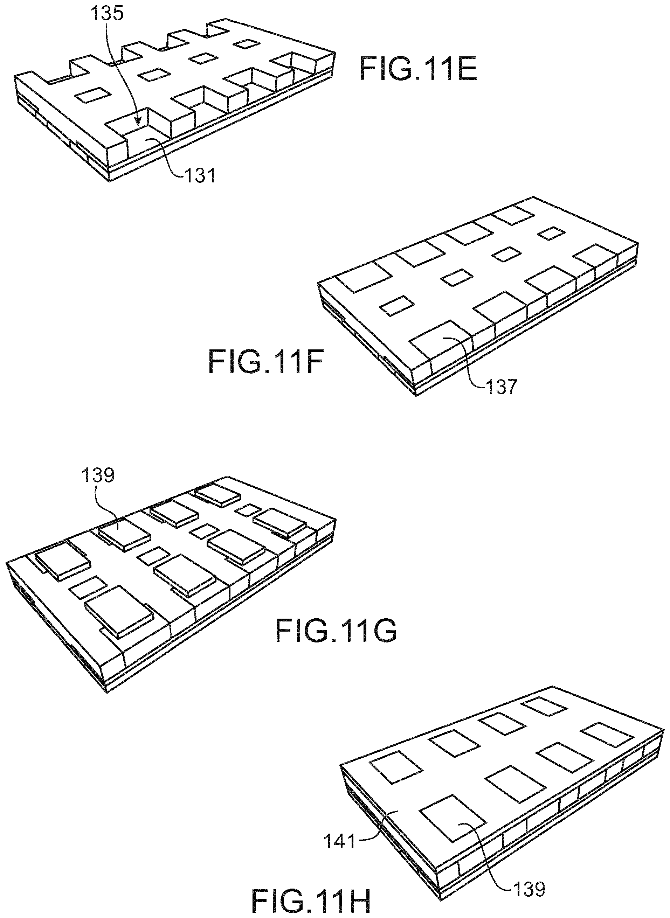

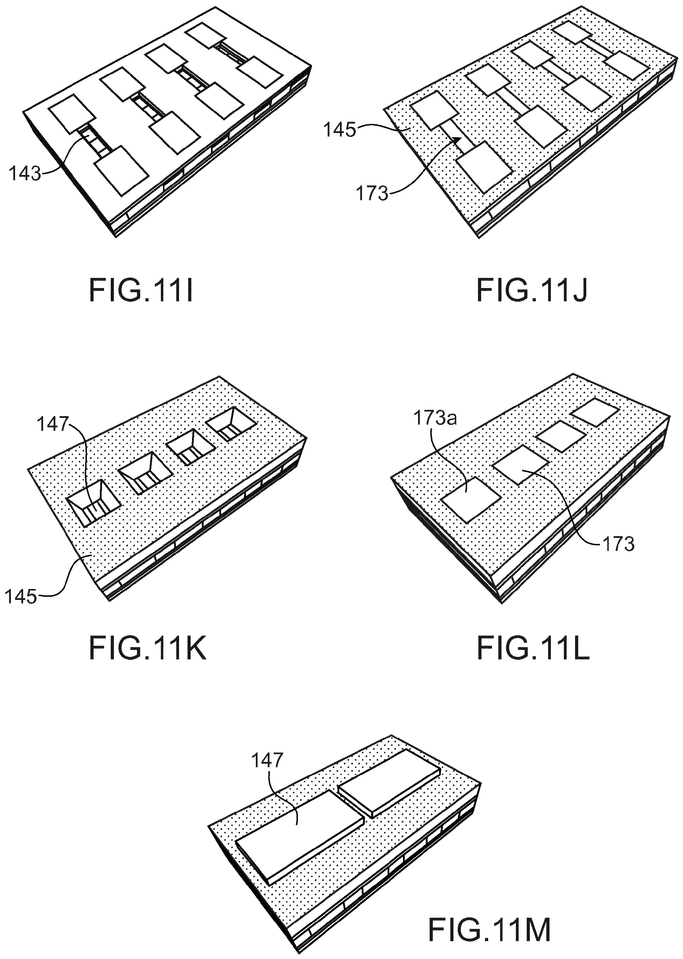

Un autre exemple de procédé de réalisation d'un commutateur dans lequel des branches de la structure de matériau à changement de phase s'étendent verticalement, va à présent être donné en liaison avec les figures 11A-11M.

Sur un substrat support, on réalise tout d'abord les électrodes 111, 113 de commande pour mettre en oeuvre le chauffage du matériau à changement de phase et des éléments conducteurs 102, 104 pour permettre en oeuvre la transmission ou le blocage d'un signal RF.

Les électrodes 111, 113 et éléments conducteurs 102, 104 peuvent être réalisés par exemple à partir du même empilement que dans l'exemple de procédé précédemment donné i.e. d'une couche de Ti d'épaisseur de 10 nm surmontée d'une couche de TiN de 40 nm recouverte d'une couche d'AICu par exemple de l'ordre de 440 nm, elle-même recouverte d'une couche de Ti par exemple de l'ordre de 10 nm, elle-même revêtue d'une couche de TiN par exemple de l'ordre de 100 nm. On forme ensuite une couche de matériau isolant 121 autour des éléments conducteurs et électrodes (figure 11A).

Puis, afin de réaliser des capacités de découplage RF connectées aux éléments conducteurs, on forme des bandes 131 de matériau diélectrique des capacités qui s'étendent sur les éléments conducteurs 102, 104 (figure 11B). Le matériau diélectrique utilisé peut être par exemple à base de SiOz, ou de SiN ou d'Al₂O₃ avec une épaisseur dépendante de la valeur de capacité souhaitée typiquement comprise entre 10 nm et 1 µm.

On dépose ensuite une couche de matériau à changement de phase 172, par exemple à base de GeTe d'épaisseur par exemple de l'ordre de 100 nm que l'on structure par exemple par gravure IBE (« Ion Beam Etching ») à l'aide d'un faisceau ionique en protégeant certaines parties par une ou plusieurs zones 132 de masque dur. Les zones 132 de masque dur sont par exemple en nitrure de silicium (SiN) avec une épaisseur par exemple de 150 nm. La gravure est effectuée de manière à former des blocs 172a de matériau à changement de phase. Les blocs 172a ont une forme élargie, ici avec une base de surface plus importante que celle de leur sommet (figure 11C).

Dans l'exemple de réalisation particulier de la figure 11C, les blocs 172a de matériau PCM peuvent avoir une forme de pyramide tronquée. Ces blocs ont ainsi une forme de section rétrécie au niveau de la région centrale de la structure PCM, afin de permettre de confiner la zone active dans cette région centrale de la structure.

Afin d'encapsuler et de passiver les blocs 172a de matériau PCM on forme ensuite au moins une couche isolante 133. La couche isolante 133 est par exemple formée d'un empilement de matériaux diélectriques comprenant une couche à base de SiN et d'épaisseur par exemple de l'ordre de 100 nm revêtue d'une autre couche à base de SiOz et d'épaisseur par exemple de l'ordre de 300 nm. On effectue ensuite une planarisation par CMP de l'empilement de matériaux diélectriques de sorte à dévoiler à nouveau les zones 132 de masque dur (figure 11D).

Dans la couche isolante 133, on forme ensuite des ouvertures 135 dévoilant les bandes 131 de matériau diélectrique des capacités de découplage RF (figure 11E).

On remplit ensuite ces ouvertures 135 d'au moins un matériau conducteur 137 afin de former une armature pour les capacités de découplage RF. Le matériau conducteur 137 peut être en particulier un matériau métallique tel que par exemple de l'AlCu d'épaisseur de l'ordre de 300 nm.

Lorsque ce matériau déborde de l'embouchure des ouvertures 135 et recouvre la couche isolante 133, on réalise ensuite une planarisation par CMP du matériau conducteur 137 de sorte à dévoiler la face supérieure de cette couche isolante 133.

Des plots conducteurs 139 sont ensuite réalisés sur et en contact avec les armatures supérieures des capacités de découplage (figure 11G). Les plots conducteurs 139 sont formés par exemple d'un empilement d'une couche de Ti d'épaisseur par exemple de 10 nm surmontée d'une couche de TiN par exemple de 40 nm recouverte d'une couche d'AICu par exemple de 440 nm, elle-même recouverte d'une couche de Ti par exemple de 10 nm, elle-même revêtue d'une couche de TiN par exemple de 100 nm. Les contacts 139 sont typiquement formées par dépôt par PVD puis gravure.

On réalise ensuite une encapsulation des plots conducteurs 139 par dépôt d'au moins une couche de matériau diélectrique 141 tel que par exemple du SiN ou du SiO₂ d'épaisseur par exemple de l'ordre de 450 nm. Une planarisation CMP peut être ensuite effectuée de manière à retirer une portion de la couche de matériau diélectrique 141 et dévoiler à nouveau la face supérieure des plots conducteurs 139.

On forme ensuite des ouvertures 143 entre les plots conducteurs 139. Les ouvertures 143 sont réalisées de manière à dévoiler les blocs 172a de la couche de matériau à changement de phase 172 (figure 11l). Une autre couche 171 de matériau à changement de phase est ensuite formée dans les ouvertures 143. Cette autre couche 171 peut être par exemple à base de GeTe et d'épaisseur de l'ordre de 300 nm. Un polissage par CMP d'une éventuelle épaisseur excédentaire de l'autre couche 171 de matériau à changement de phase peut être ensuite réalisé de sorte à dévoiler à nouveau les plots conducteurs 139 et le diélectrique d'encapsulation.

Avantageusement, on peut réaliser une sur-gravure, afin de réduire de la couche 171 de matériau à changement de phase, en particulier au centre du motif situé entre les plots conducteurs 139.

Cela permet de localiser de manière plus précise la zone active dans la structure de matériau(x) à changement de phase.

On forme ensuite une autre couche isolante 145 d'encapsulation à base d'un matériau diélectrique tel que par exemple du SiN ou du SiO₂ d'épaisseur par exemple de l'ordre de 100 nm.

On réalise des ouvertures 147 dans cette couche isolante 145 d'encapsulation. Les ouvertures 147 dévoilent la couche 173 de matériau à changement de phase.

Dans cet exemple, les ouvertures 147 ont un fond avec une section prise parallèlement au plan principal du substrat 100 qui est inférieure à une section prise parallèlement au plan principal du substrat 100 de l'embouchure des ouvertures 147. Les ouvertures 147 ont dans cet exemple une forme de pyramide tronquée dont la base correspond à l'embouchure et dont le sommet correspond au fond des ouvertures 147.

Une autre couche 173 de matériau à changement de phase tel que par exemple du GeTe d'épaisseur 300 nm est ensuite déposée dans les ouvertures 149. Un polissage par CMP d'une éventuelle épaisseur excédentaire de la couche 173 de matériau à changement de phase peut être ensuite réalisé de sorte à dévoiler à nouveau la couche isolante 145 d'encapsulation. La couche 173 dans les ouvertures 147 réalise des blocs 173a de matériau à changement de phase ayant une forme de pyramide tronquée.

Des contacts 147 sont ensuite réalisés sur les blocs 173a de matériau à changement de phase, chaque contact 147 pouvant être agencé sur plusieurs blocs 173a de matériau PCM. Les contacts 147 peuvent être formés par dépôts successifs de sorte à réaliser un empilement conducteur comprenant par exemple une couche de Ti d'épaisseur par exemple de l'ordre de 20 nm et une couche d'Au d'épaisseur par exemple de l'ordre de 400 nm ou une couche de TiN d'épaisseur par exemple de l'ordre de 100 nm.

## Revendications

1. Commutateur apte à connecter, ou à interrompre une connexion entre, un premier élément conducteur (2, 102) et un deuxième élément conducteur (4, 104), comprenant, sur un support (0):
- le premier élément conducteur (2, 102) et le deuxième élément conducteur (4, 104),
- une structure à base d'au moins un matériau à changement de phase (7) disposée entre le premier élément conducteur (2, 102) et le deuxième élément conducteur (4, 104), le matériau à changement de phase étant apte à changer d'état entre un état cristallin dans lequel le matériau à changement de phase a une première résistivité et un état amorphe dans lequel le matériau à changement de phase a une deuxième résistivité plus importante que la première résistivité, et lorsqu'une zone appelée « zone active » située dans une région centrale (80, 180) de ladite structure à base de matériau à changement de phase est dans un état cristallin, la région centrale (80, 180) étant disposée entre le premier élément conducteur (2, 102) et le deuxième élément conducteur (4, 104) et entre une première électrode (11, 111) d'un moyen de chauffage du matériau à changement de phase et une deuxième électrode (13, 113) du moyen de chauffage du matériau à changement de phase, le commutateur est dans un état passant et le premier élément conducteur et le deuxième élément conducteur sont connectés l'un à l'autre tandis que lorsque la zone active de ladite structure à base de matériau à changement de phase est dans un état amorphe, le commutateur est dans un état bloqué,
- le moyen de chauffage du matériau à changement de phase doté de la première électrode (11, 111) et de la deuxième électrode (13, 113), pour appliquer un signal d'activation électrique et faire passer la zone active d'un état amorphe à un état cristallin ou d'un état cristallin à un état amorphe, la structure de matériau à changement de phase étant dotée en outre d'une troisième branche (81a, 181a) et d'une quatrième branche (81b, 181b), distinctes et qui s'étendent autour de la région centrale (80, 180), la troisième branche (81a, 181a) étant en contact avec la première électrode (11, 111), et la quatrième branche en contact avec la deuxième électrode (13, 113), le commutateur étant **caractérisé en ce que**
la structure de matériau à changement de phase est dotée également d'une première branche (82a, 182a) et d'une deuxième branche (82b, 182b), distinctes, et distinctes de la troisième branche (81a, 181a) et de la quatrième branche (81b, 181b), et qui s'étendent autour de la région centrale (80, 180), la première branche (82a, 182a) étant en contact avec le premier élément conducteur (2, 102) et la deuxième branche (82b, 182b) étant en contact avec le deuxième élément conducteur (4, 104), et **en ce que** la troisième branche (81a, 181a) et/ou la quatrième branche (81b, 181b) a dans une zone en contact avec la région centrale (80) une section plus étroite que dans une zone en contact avec l'électrode (11, 111, 13, 113) avec laquelle elle est en contact.

2. Commutateur selon la revendication 1, la première branche (82a, 182a) et/ou la deuxième branche (82b, 182b) ayant dans une zone en contact avec la région centrale (80) une section plus étroite que dans une zone en contact avec l'élément conducteur (2, 102, 4, 104) avec laquelle elle est en contact.

3. Commutateur selon l'une des revendications 1 ou 2, dans lequel au moins une desdites branches (81a, 81b, 82a, 82b) a une section rétrécie au-fur et à mesure que l'on se rapproche de la région centrale (80).

4. Commutateur selon la revendication 1, la troisième branche (81a, 181a), et la quatrième branche (81b, 181b) ayant une largeur inférieure à la largeur de la première branche (82a, 182a) et de la deuxième branche (82b, 182b).

5. Commutateur selon l'une des revendications 1 à 4, le moyen de chauffage étant apte à mettre dans un état amorphe un volume central appelé la zone active (8) de la structure de matériau à changement de phase, la structure de matériau à changement de phase étant configurée de sorte que le volume central n'est pas en contact avec le premier élément conducteur et le deuxième élément conducteur et est disposé entre un premier volume de la première branche (82a, 182a) de matériau à changement de phase dans un état cristallin en contact avec le premier élément conducteur et un deuxième volume de la deuxième branche (82b, 182b) matériau à changement de phase dans un état cristallin en contact avec le deuxième élément conducteur de telle sorte que le volume central sépare le premier volume du deuxième volume, le volume central étant inférieur ou égal à 1/3 du volume cumulé total entre le premier volume, le deuxième volume et le volume central.

6. Commutateur selon l'une des revendications 1 à 5, dans lequel la première branche (82a), la deuxième branche (82b), la troisième branche (81a) et la quatrième branche (81b) s'étendent parallèlement à un plan principal du support (0).

7. Commutateur selon l'une des revendications 1 à 5, dans lequel la première branche (82a) et la deuxième branche (82b) s'étendent dans un premier plan, la troisième branche (81a) et la quatrième branche (81b) s'étendent dans un deuxième plan, le premier plan et le deuxième plan réalisant entre eux un angle non-nul, en particulier de 90°.

8. Commutateur selon la revendication 6, dans lequel, la structure (8) de matériau à changement de phase est formée entre la première électrode (11) et la deuxième électrode (13) d'un empilement comprenant une première couche (71) à base d'un premier matériau à changement de phase, la première couche étant disposée entre une deuxième couche (72) et une troisième couche (73), la deuxième couche et la troisième couche étant à base d'au moins un deuxième matériau à changement de phase différent du premier matériau à changement de phase.

9. Commutateur selon la revendication 7, le premier matériau à changement de phase ayant une température de fusion inférieure à la température de fusion du deuxième matériau à changement de phase et/ou une conductivité thermique plus élevée que la conductivité thermique du deuxième matériau à changement de phase.

10. Commutateur selon l'une des revendications 7 à 9, dans lequel la structure de matériau à changement de phase est formée entre la première électrode et la deuxième électrode d'un empilement comprenant une première couche de matériau à changement de phase disposée entre une deuxième couche de matériau à changement de phase et une troisième couche à base de matériau à changement de phase, la deuxième couche de matériau à changement de phase et la troisième couche de matériau à changement de phase ayant des sections respectives rétrécies au fur et à mesure que l'on s'éloigne respectivement de la première électrode et de la deuxième électrode et que l'on se rapproche de la première couche de matériau à changement de phase.

11. Commutateur selon l'une des revendications 7 à 9, dans lequel la première électrode et la deuxième électrode sont disposées dans un plan orthogonal au plan principal du support, la structure de matériau à changement de phase est formée entre la première électrode et la deuxième électrode d'un empilement comprenant une première couche de matériau à changement de phase disposée entre une deuxième couche de matériau à changement de phase et une troisième couche de matériau à changement de phase, au moins la première couche de matériau à changement de phase comportant une portion amincie disposée entre une portion de la deuxième couche de matériau à changement de phase et une portion de la troisième couche de matériau à changement de phase.

12. Dispositif comprenant au moins un commutateur selon l'une des revendications 1 à 11, le commutateur étant un commutateur RF, apte à acheminer un signal RF ou à interrompre l'acheminement de signal RF entre le premier élément conducteur (2, 102) et le deuxième élément conducteur (4, 104).

13. Dispositif comprenant au moins un commutateur selon l'une des revendications 1 à 11, le commutateur dans lequel entre la première branche et la quatrième branche, une première portion isolante est agencée, une deuxième portion isolante étant disposée entre la quatrième branche et la deuxième branche, une troisième portion isolante étant prévue entre la deuxième branche et la troisième branche, une quatrième portion isolante étant prévue entre la troisième branche et la première branche.

14. Système commutateur comprenant une pluralité de commutateurs selon l'une des revendications 1 à 11, les commutateurs étant agencés en parallèle de sorte que les premiers éléments conducteurs (2) respectifs des commutateurs sont connectés entre eux et de sorte que les deuxièmes éléments conducteurs (4) respectifs des commutateurs sont connectés entre eux.

15. Système commutateur comprenant :
- un premier moyen de polarisation et un deuxième moyen de polarisation,
- une pluralité de commutateurs selon l'une des revendications 1 à 11, dans lequel les premières électrodes (11, 111) respectives des commutateurs sont connectées entre elles et au premier moyen de polarisation, les deuxièmes électrodes (13, 113) respectives des commutateurs étant connectées entre elles et au deuxième de polarisation,
ou dans lequel la première électrode (11, 111) d'un premier commutateur est connecté au premier moyen de polarisation, la deuxième électrode du premier commutateur étant connectée à la première électrode d'un commutateur suivant, et la deuxième électrode d'un dernier commutateur est connecté au deuxième moyen de polarisation.

## Patentansprüche

1. Schalter, der in der Lage ist, eine Verbindung zwischen einem ersten leitenden Element (2, 102) und einem zweiten leitenden Element (4, 104) zu verbinden oder zu unterbrechen, umfassend, auf einem Träger (0):
- das erste leitende Element (2, 102) und das zweite leitende Element (4, 104),
- eine Struktur auf Basis von mindestens einem Phasenwechselmaterial (7), die zwischen dem ersten leitenden Element (2, 102) und dem zweiten leitenden Element (4, 104) angeordnet ist, wobei das Phasenwechselmaterial in der Lage ist, seinen Zustand zwischen einem kristallinen Zustand, in dem das Phasenwechselmaterial einen ersten spezifischen Widerstand aufweist, und einem amorphen Zustand, in dem das Phasenwechselmaterial einen zweiten spezifischen Widerstand aufweist, der größer ist als der erste spezifische Widerstand, zu wechseln, und, wenn sich eine als "aktive Zone" bezeichnete Zone, die in einem zentralen Bereich (80,180) der Struktur auf Basis von Phasenwechselmaterial liegt, wobei der zentrale Bereich (80, 180) zwischen dem ersten leitenden Element (2, 102) und dem zweiten leitenden Element (4, 104) und zwischen einer ersten Elektrode (11, 111) eines Mittels zum Heizen des Phasenwechselmaterials und einer zweiten Elektrode (13, 113) des Mittels zum Heizen des Phasenwechselmaterials angeordnet ist, in einem kristallinen Zustand befindet, sich der Schalter in einem Durchlasszustand befindet und das erste leitende Element und das zweite leitende Element miteinander verbunden sind, wohingegen, wenn sich die aktive Zone der Struktur auf Basis von Phasenwechselmaterial in einem amorphen Zustand befindet, sich der Schalter in einem Sperrzustand befindet,
- das Mittel zum Heizen des Phasenwechselmaterials, das mit der ersten Elektrode (11, 111) und mit der zweiten Elektrode (13, 113) versehen ist, um ein elektrisches Aktivierungssignal anzulegen und die aktive Zone von einem amorphen Zustand in einen kristallinen Zustand oder von einem kristallinen Zustand in einen amorphen Zustand übergehen zu lassen,
wobei die Struktur aus Phasenwechselmaterial weiter mit einem dritten Zweig (81a, 181a) und einem vierten Zweig (81b, 181b) versehen ist, die sich unterscheiden und die sich um den zentralen Bereich (80, 180) herum erstrecken,
wobei sich der dritte Zweig (81a, 181a) mit der ersten Elektrode (11, 111) in Kontakt befindet, und der vierte Zweig mit der zweiten Elektrode (13, 113) in Kontakt,
wobei der Schalter **dadurch gekennzeichnet ist, dass**
die Struktur aus Phasenwechselmaterial ebenfalls mit einem ersten Zweig (82a, 182a) und einem zweiten Zweig (82b, 182b) versehen ist, die sich unterscheiden und die sich vom dritten Zweig (81a, 181a) und vom vierten Zweig (81b, 181b) unterscheiden und die sich um den zentralen Bereich (80, 180) herum erstrecken, wobei sich der erste Zweig (82a, 182a) mit dem ersten leitenden Element (2, 102) in Kontakt befindet und der zweite Zweig (82b, 182b) mit dem zweiten leitenden Element (4, 104) in Kontakt befindet, und dadurch, dass der dritte Zweig (81a, 181a) und/oder der vierte Zweig (81b, 181b) in einer Zone, die sich mit dem zentralen Bereich (80) in Kontakt befindet, einen engeren Querschnitt aufweist als in einer Zone, die sich mit der Elektrode (11, 111, 13, 113), mit welcher er sich in Kontakt befindet, in Kontakt befindet.

2. Schalter nach Anspruch 1, wobei der erste Zweig (82a, 182a) und/oder der zweite Zweig (82b, 182b) in einer Zone, die sich mit dem zentralen Bereich (80) in Kontakt befindet, einen engeren Querschnitt aufweist als in einer Zone, die sich mit dem leitenden Element (2, 102,4,104), mit welcher er sich in Kontakt befindet, in Kontakt befindet.

3. Schalter nach einem der Ansprüche 1 oder 2, wobei mindestens einer der Zweige (81a, 81b, 82a, 82b) einen mit zunehmender Annäherung an den zentralen Bereich (80) verengten Querschnitt aufweist.

4. Schalter nach Anspruch 1, wobei der dritte Zweig (81a, 181a) und der vierte Zweig (81b, 181b) eine kleinere Breite als die Breite des ersten Zweigs (82a, 182a) und des zweiten Zweigs (82b, 182b) aufweisen.

5. Schalter nach einem der Ansprüche 1 bis 4, wobei das Heizmittel in der Lage ist, ein als die aktive Zone (8) der Struktur aus Phasenwechselmaterial bezeichnetes zentrales Volumen in einen amorphen Zustand zu versetzen, wobei die Struktur aus Phasenwechselmaterial so ausgelegt ist, dass sich das zentrale Volumen nicht mit dem ersten leitenden Element und dem zweiten leitenden Element in Kontakt befindet und derart zwischen einem ersten Volumen des ersten Zweigs (82a, 182a) aus Phasenwechselmaterial in einem kristallinen Zustand, das sich mit dem ersten leitenden Element in Kontakt befindet, und einem zweiten Volumen des zweiten Zweigs (82b, 182b) aus Phasenwechselmaterial in einem kristallinen Zustand, das sich mit dem zweiten leitenden Element in Kontakt befindet, angeordnet ist, dass das zentrale Volumen das erste Volumen vom zweiten Volumen trennt, wobei das zentrale Volumen kleiner oder gleich 1/3 des kumulierten Gesamtvolumens zwischen dem ersten Volumen, dem zweiten Volumen und dem zentralen Volumen ist.

6. Schalter nach einem der Ansprüche 1 bis 5, wobei sich der erste Zweig (82a), der zweite Zweig (82b), der dritte Zweig (81a) und der vierte Zweig (81b) parallel zu einer Hauptebene des Trägers (0) erstrecken.

7. Schalter nach einem der Ansprüche 1 bis 5, wobei sich der erste Zweig (82a) und der zweite Zweig (82b) in einer ersten Ebene erstrecken, der dritte Zweig (81a) und der vierte Zweig (81b) sich in einer zweiten Ebene erstrecken, wobei die erste Ebene und die zweite Ebene zwischen sich einen Winkel von ungleich null, insbesondere von 90°, bilden.

8. Schalter nach Anspruch 6, wobei die Struktur (8) aus Phasenwechselmaterial zwischen der ersten Elektrode (11) und der zweiten Elektrode (13) von einem Stapel gebildet wird, der eine erste Schicht (71) auf Basis eines ersten Phasenwechselmaterials umfasst, wobei die erste Schicht zwischen einer zweiten Schicht (72) und einer dritten Schicht (73) angeordnet ist, wobei die zweite Schicht und die dritte Schicht auf Basis von mindestens einem zweiten Phasenwechselmaterial sind, das sich vom ersten Phasenwechselmaterial unterscheidet.

9. Schalter nach Anspruch 7, wobei das erste Phasenwechselmaterial eine niedrigere Schmelztemperatur als die Schmelztemperatur des zweiten Phasenwechselmaterials und/oder eine höhere Wärmeleitfähigkeit als die Wärmeleitfähigkeit des zweiten Phasenwechselmaterials aufweist.

10. Schalter nach einem der Ansprüche 7 bis 9, wobei die Struktur aus Phasenwechselmaterial zwischen der ersten Elektrode und der zweiten Elektrode von einem Stapel gebildet wird, der eine erste Schicht aus Phasenwechselmaterial umfasst, die zwischen einer zweiten Schicht aus Phasenwechselmaterial und einer dritten Schicht auf Basis von Phasenwechselmaterial angeordnet ist, wobei die zweite Schicht aus Phasenwechselmaterial und die dritte Schicht aus Phasenwechselmaterial jeweilige, mit zunehmender jeweiliger Entfernung von der ersten Elektrode und der zweiten Elektrode und mit zunehmender Annäherung an die erste Schicht aus Phasenwechselmaterial verengte Querschnitte aufweisen.

11. Schalter nach einem der Ansprüche 7 bis 9, wobei die erste Elektrode und die zweite Elektrode in einer zur Hauptebene des Trägers orthogonalen Ebene angeordnet sind, die Struktur aus Phasenwechselmaterial zwischen der ersten Elektrode und der zweiten Elektrode von einem Stapel gebildet wird, der eine erste Schicht aus Phasenwechselmaterial umfasst, die zwischen einer zweiten Schicht aus Phasenwechselmaterial und einer dritten Schicht aus Phasenwechselmaterial angeordnet ist, wobei mindestens die erste Schicht aus Phasenwechselmaterial einen verdünnten Abschnitt umfasst, der zwischen einem Abschnitt der zweiten Schicht aus Phasenwechselmaterial und einem Abschnitt der dritten Schicht aus Phasenwechselmaterial angeordnet ist.

12. Vorrichtung, die mindestens einen Schalter nach einem der Ansprüche 1 bis 11 umfasst, wobei es sich bei dem Schalter um einen HF-Schalter handelt, der in der Lage ist, ein HF-Signal zu übertragen oder die Übertragung des HF-Signals zwischen dem ersten leitenden Element (2, 102) und dem zweiten leitenden Element (4, 104) zu unterbrechen.

13. Vorrichtung, die mindestens einen Schalter nach einem der Ansprüche 1 bis 11 umfasst, wobei in dem Schalter zwischen dem ersten Zweig und dem vierten Zweig ein erster isolierender Abschnitt eingerichtet ist, wobei zwischen dem vierten Zweig und dem zweiten Zweig ein zweiter isolierender Abschnitt angeordnet ist, wobei zwischen dem zweiten Zweig und dem dritten Zweig ein dritter isolierender Abschnitt vorgesehen ist, wobei zwischen dem dritten Zweig und dem ersten Zweig ein vierter isolierender Abschnitt vorgesehen ist.

14. Schaltersystem, das eine Vielzahl von Schaltern nach einem der Ansprüche 1 bis 11 umfasst, wobei die Schalter parallel geschaltet sind, sodass die jeweiligen ersten leitenden Elemente (2) der Schalter miteinander verbunden sind und sodass die jeweiligen zweiten leitenden Elemente (4) der Schalter miteinander verbunden sind.

15. Schaltersystem, umfassend:
- ein erstes Polarisationsmittel und ein zweites Polarisationsmittel,
- eine Vielzahl von Schaltern nach einem der Ansprüche 1 bis 11, wobei die jeweiligen ersten Elektroden (11, 111) der Schalter miteinander und mit dem ersten Polarisationsmittel verbunden sind, wobei die jeweiligen zweiten Elektroden (13, 113) der Schalter miteinander und mit dem zweiten Polarisation verbunden sind,
oder wobei die erste Elektrode (11, 111) eines ersten Schalters mit dem ersten Polarisationsmittel verbunden ist, wobei die zweite Elektrode des ersten Schalters mit der ersten Elektrode eines folgenden Schalters verbunden ist, und die zweite Elektrode eines letzten Schalters mit dem zweiten Polarisationsmittel verbunden ist.

## Claims

1. Selector switch capable of making or breaking a connection between at least one first conducting element (2, 102) and at least one second conducting element (4, 104), comprising the following, on a support (0):
- the first conducting element (2, 102) and the second conducting element (4, 104),
- a structure based on at least one phase change material (7) located between the first conducting element (2,102) and the second conducting element (4, 104), the phase change material being capable of changing state between a crystalline state wherein the phase change material has a first resistivity and an amorphous state wherein the phase change material has a second resistivity higher than the first resistivity,
and when a zone called an "active zone" situated in a central region (80, 180) of said structure based on at least one phase change material (7) is in a crystalline state, the central region (80, 180) being located between the first conducting element (2, 102) and the second conducting element (4, 104) and between a first electrode (11, 111) of a heating mean of the phase change material and a second electrode of the heating mean of the phase change material, the switch is in a conducting state and the first conducting element (2, 102) and the second conducting element (4, 104) are connected to each other, whereas when the active zone of said structure based on at least one phase change material (7) is in an amorphous state, the switch is in a blocked state,
- the heating mean of the phase change material being provided with the first electrode (11, 111) and the second electrode (13, 113) for applying an activation electrical signal and to change said active zone from a crystalline state to an amorphous state or from an amorphous state to a crystalline state,
the phase change material structure also being provided with a third branch (81a, 181a) and a fourth branch (81b, 181b), that are distinct and that extend around the central region (80, 180), the third branch (81a, 181a) being in contact with the first electrode (11, 111) and the fourth branch being in contact with the second electrode (13, 113),
the switch being **characterized in that** the phase change material structure is provided with a first branch (82a, 182a) and a second branch (82b, 182b), that are distinct from each other and distinct from the third branch (81a, 181a) and from the fourth branch (81b, 181b) and that extend around the central region (80, 180), the first branch (82a, 182a) being in contact with the first conducting element (2, 102) and the second branch being in contact with the second conducting element (4, 104),
and **in that** the third branch(es) (81a, 181a) and/or the fourth branch(es) (81b, 181b) have a narrower section in a zone in contact with the central region (80) than in a zone in contact with the electrode (11, 111, 13, 113) with which it is in contact.

2. Selector switch according to claim 1, the first branch (82a, 182a) and/or the second branch (82b, 182b) having a narrower section in a zone in contact with the central region (80) than in a zone in contact with the conducting element (2, 102, 4, 104) with which it is in contact.

3. Selector switch according to claim 1 or 2, in which the section of at least one of said branches (81a, 81b, 82a, 82b) becomes narrower as the distance from the central region (80) reduces.

4. Selector switch according to claim 1, the widths of the third branch (81a, 181a) and the fourth branch (81b, 181b) being less than the widths of the first branch (82a, 182a) and the second branch (82b, 182b).

5. Selector switch according to any of the claims 1 to 4, the means of heating being capable of putting a central volume called the active zone (8) of the phase change material structure into an amorphous state, the phase change material structure being configured such that the central volume is not in contact with the first conducting element and the second conducting element and is located between a first volume of the first branch (82a, 182a) of phase change material in a crystalline state in contact with the first conducting element and a second volume of the second branch (82b, 182b) of phase change material in a crystalline state in contact with the second conducting element such that the central volume separates the first volume from the second volume, the central volume being smaller than or equal to 1/3 of the total accumulated volume including the first volume, the second volume and the central volume.

6. Selector switch according to any of the claims 1 to 5, in which the first branch (82a), the second branch (82b), the third branch (81a) and the fourth branch (81b) extend parallel to a principal plane of the support (0).

7. Selector switch according to any of the claims 1 to 5, wherein the first branch (82a) and the second branch (82b) extend in a first plane, the third branch (81a) and the fourth branch (81b) extending in a second plane, the angle between the first plane and the second plane not being null, and particularly 90°.

8. Selector switch according to claim 6, wherein the phase change material structure (8) is formed between the first electrode (11) and the second electrode (13) of a stack comprising a first layer (71) based on a first phase change material, the first layer being located between a second layer (72) and a third layer (73), the second layer and the third layer being based on at least one second phase change material different from the first phase change material.

9. Selector switch according to claim 7, the melting temperature of the first phase change material being less than the melting temperature of the second phase change material and/or its thermal conductivity being higher than the thermal conductivity of the second phase change material.

10. Selector switch according to any of claims 7 to 9, wherein the phase change material structure is formed between the first electrode and the second electrode of a stack comprising a first layer of phase change material located between a second layer of phase change material and a third layer based on a phase change material, the sections of the second layer of phase change material and the third layer of phase change material becoming narrower as the distances from the first electrode and the second electrode respectively increase and as the distance from the first layer of phase change material reduces.

11. Selector switch according to any of claims 7 to 9, wherein the first electrode and the second electrode are located in a plane orthogonal to the principal plane of the support, the phase change material structure is formed between the first electrode and the second electrode of a stack comprising a first layer of a first phase change material located between a second layer of phase change material and a third layer of phase change material, at least the first layer of phase change material comprising a thinned portion located between a portion of the second layer of phase change material and a portion of the third layer of phase change material.

12. Device comprising at least one selector switch according to any of the claims 1 to 11, the selector switch being an RF selector switch, capable of routing an RF signal or interrupting routing of an RF signal between the first conducting element (2, 102) and the second conducting element (4, 104).

13. Switching system comprising a plurality of selector switches according to any of the claims 1 to 11, the selector switches being arranged in parallel such that the first conducting elements of each of the selector switches are connected to each other and such that the second conducting elements of each of the selector switches are connected to each other.

14. Switching system comprising a plurality of selector switches according to any of the claims 1 to 11, the switches being arranged in parallel so that the respective first conducting elements (2) of the selector switches are connected to each other and the respective second conducting elements (4) of the selector switches being connected to each other.

15. Switching system comprising:
- a first biasing mean and a second biasing mean,
- a plurality of selector switches according to any of the claims 1 to 11,
wherein the first electrodes (11, 111) of the selector switches are connected to each other and to a first biasing mean, the second electrodes (13, 113) of the selector switches being connected to each other and to a second biasing mean, or the first electrodes (11, 111) of a first selector switch is connected to a first biasing mean, the second electrode (13, 113) of the first selector switch is connected to the first electrode of a following selector switch, the second electrode of a last selector switch is connected to a second biasing mean.
